# EUROPEAN PATENT SPECIFICATION

(11) **EP 1 680 923 B1**
(45) Date of publication and mention of the grant of the patent: **13.03.2013**
(21) Application number: 04799973.5
(22) Date of filing: 01.11.2004
(51) Int. Cl.: H04N 7/24, H04L 5/00, H04B 7/00

(54) **ROBUST ERROR CORRECTION ENCODING/DECODING APPARATUS AND METHOD FOR DIGITAL DUAL-STREAM BROADCAST RECEPTION/TRANSMISSION SYSTEMS**
ROBUSTE FEHLERKORREKTUR-CODIERUNGS-/-DECODIERUNGS-VORRICHTUNG UND VERFAHREN FÜR DIGITALE DOPPELSTROM-BROADCAST-EMPFANGS-/-SENDESYSTEME
APPAREIL ET PROCEDE DE CODAGE/DECODAGE DE CORRECTION D'ERREURS ROBUSTE POUR SYSTEMES DE RECEPTION/TRANSMISSION A DIFFUSION DE DOUBLE TRAINS DE DONNEES NUMERIQUES

(30) Priority: 03.11.2003 US 516270 P; 02.03.2004 KR 2004014054
(43) Date of publication of application: 19.07.2006
(73) Proprietor: Samsung Electronics Co., Ltd., Suwon-si, Gyeonggi-do, 443-742 (KR)
(72) Inventor: CHANG, Yong-deok, 105-705, Dongsuwon LG Village, Suwon-si, Gyeonggi-do 443-706 (KR); JEONG, Hae-joo, 8-1005, Seongsan Siyoung Apartment, Seoul 121-781 (KR); PARK, Sung-woo, Gyeonggi-do 443-370 (KR)
(74) Representative: Davies, Robert Ean
(86) International application number: PCT/KR2004/002782
(87) International publication number: WO 2005/043916

(56) References cited:
- US-A1- 2002 124 225
- US-A1- 2002 126 222
- US-A1- 2002 191 712
- US-A1- 2002 194 570
- US-A1- 2003 099 303
- US-A1- 2003 099 303
- US-A1- 2004 057 535

## Description

### Technical Field

The present invention relates to an error correction encoding/decoding apparatus for American ATSC digital terrestrial broadcast reception/transmission systems, and more particularly to a robust error correction encoding/decoding apparatus and method for digital dual-stream broadcast reception/transmission systems which split data into normal and robust data for processing, receiving, and transmitting the data.

### Background Art

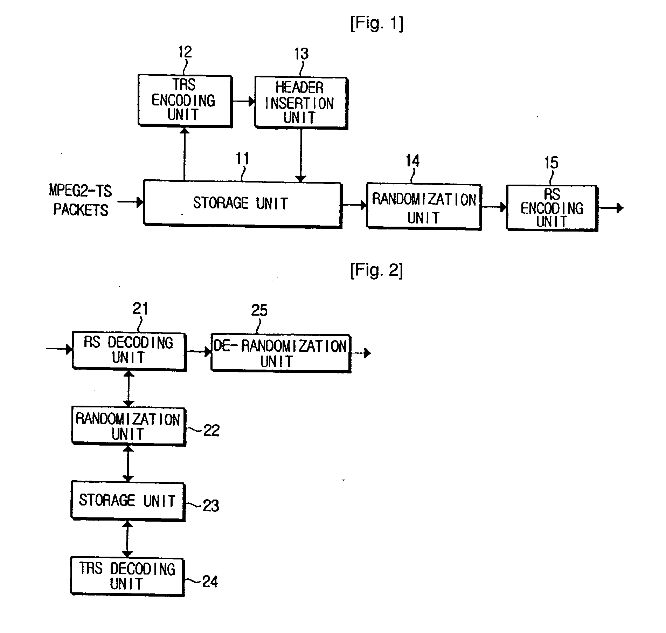

FIG. 1 and FIG. 2 are block diagrams for schematically showing an American ATSC standard reception/transmission system disclosed in Republic of Korea Patent Application No 2003-0067522 filed by the Applicant.

In a transmission system as shown in FIG. 1, the Transversal Reed Solomon(TRS) encoding unit 12 produces parity packets in columns with respect to MPEG2-TS packets stored in the storage unit 11, and the header insertion unit 13 inserts parity packet headers(PIDs) for compatibility with existing reception systems. Next, the data packets and parity packets are randomized in a certain pattern by the randomization unit 14, and the RS encoding unit 15 generates and adds 20-byte parities to the data packets and parity packets.

On the other hand, FIG. 2 is a block diagram for schematically showing a reception system corresponding to the reception/transmission system shown in FIG. 1. The RS decoding unit 21 corrects errors of data packets and parity packets in row direction by using 20-byte parities added to individual packets.

The randomization unit 22 de-randomizes the data packets and parity packets error-corrected in the row direction by the RS decoding unit 21, and stores the de-randomized data packets and parity packets in the storage unit 23. The TRS decoding unit 24 corrects data packet errors in the column direction by use of the de-randomized parity packets, and updates the stored data.

Next, the randomization unit 22 randomizes the de-randomized data packets and parity packets, and the RS decoding unit 21 corrects errors in the row direction in the row direction by using the parity packets once more, and the de-randomization unit 25 de-randomizes the packets.

### Disclosure of Invention

### Technical Problem

However, As above, the Republic of Korea Patent Application No. 2003-0067522 filed by the Applicant discloses only the concept of applying the TRS encoding and decoding to the digital dual-stream broadcast receptions and transmissions in which data split into the normal and robust data is sent together, but does not disclose concrete embodiments.

### Technical Solution

The present invention has been developed in order to solve the above drawbacks and other problems associated with the conventional arrangement. An aspect of the present invention is to provide an error correction encoding/decoding apparatus and method for digital dual-stream broadcast reception/transmission systems in which the transversal reed Solomon encoding/decoding method is applied.

The foregoing and other objects and advantages are substantially realized by providing an error correction encoding apparatus for digital dual-stream broadcast transmission systems, according to the first embodiment of the present invention, comprising a Transversal Reed-Solomon(TRS) encoding part for applying the transversal encoding to normal data packets and robust data packets and appending parity packets; a randomization unit for randomizing the data packets and the parity packets according to a predetermined pattern; an RS encoding unit for encoding the randomized data packets and parity packets and appending parities of predetermined bytes; a packet format unit for splitting the data packets and the parity packets into normal data and robust data and processing the data according to respective data formats; and a system control unit for controlling the packet format unit to split into the normal data and the robust data and process the data packets and the parity packets.

The foregoing and other objects and advantages are substantially realized by providing an error correction encoding apparatus for digital dual-stream broadcast transmission systems, according to the second embodiment of the present invention, comprising a randomization unit for randomizing normal data packets and robust data packets according to a predetermined pattern; a TRS encoding part for applying the transversal encoding to the randomized normal data packets and robust data packets and appending parity packets; an RS encoding unit for appending parities of predetermined bytes to the data packets and the parity packets; a packet format unit for splitting the data packets and the parity packets into normal data and robust data and processing the data according to respective data formats; and a system control unit for controlling the packet format unit to split into the normal data and the robust data and process the data packets and the parity packets. The randomization unit randomizes the parity packets in accordance with a predetermined pattern.

The foregoing and other objects and advantages are substantially realized by providing an error correction encoding apparatus for digital dual-stream broadcast transmission systems, according to the third embodiment of the present invention, comprising a randomization unit for randomizing normal data packets and robust data packets according to a predetermined pattern; an RS encoding unit for appending parities of predetermined bytes to the data packets; a TRS encoding part for applying the transversal encoding to the data packets and appending parity packets; and a packet format unit for splitting the data packets and the parity packets into normal data and robust data and processing the data according to respective data formats, wherein the randomization unit randomizes the parity packets according to the predetermined pattern and the RS encoding unit appends the parity of predetermined bytes to the randomized parity packets.

The foregoing and other objects and advantages are substantially realized by providing an error correction decoding apparatus for digital dual-stream broadcast reception systems, according to the fourth embodiment of the present invention, comprising a packet re-format unit for splitting input data packets and parity packets into normal data and robust data and processing data according to respective data formats; an RS decoding unit for correcting errors of the packets by use of parities of predetermined bytes included in the packets; a de-randomization/randomization unit for de-randomizing the packets corresponding to error correction encoding; and a TRS decoding part for correcting errors of the packets by use of the parity packets, wherein the de-randomization/randomization unit randomizes the packets error-corrected in the TRS decoding part.

### Advantageous Effects

As aforementioned, the present invention can provide error correction encoding/decoding apparatus and method for digital dual-stream broadcast transmission/reception systems to which the TRS encoding and decoding are applied.

The digital dual-stream broadcast transmission/reception system according to the present invention can obtain an SNR gain with respect to normal data and robust data by applying the TRS encoding, and improve the performance of an equalizer together with the SNR gain by carrying out the robust data process with respect to parity packets of normal data.

The foregoing embodiments and advantages are merely exemplary and are not to be construed as limiting the present invention. The present teaching can be readily applied to other types of apparatuses. Also, the description of the embodiments of the present invention is intended to be illustrative, and not to limit the scope of the claims, and many alternatives, modifications, and variations will be apparent to those skilled in the art.

### Description of Drawings

The above aspects and features of the present invention will be more apparent by describing certain embodiments of the present invention with reference to the accompanying drawings, in which:

FIG. 1 and FIG. 2 are block diagrams for schematically showing an error correction encoding/decoding apparatus disclosed in Republic Of Korea Patent Application No. 2003-0067522 filed by the Applicant;

FIG. 3 is a block diagram for schematically showing an error correction encoding apparatus for digital dual-stream broadcast transmission systems according to the first embodiment of the present invention;

FIG. 4 through FIG. 6 are views for showing structures of dual-stream transmission data frames;

FIG. 7 is a flow chart for showing an error correction encoding process for the error correction encoding apparatus of FIG. 3;

FIG. 8 is a block diagram for schematically showing an error correction encoding apparatus for digital dual-stream broadcast transmission systems according to the second embodiment of the present invention;

FIG. 9 is a flow chart for showing an error correction encoding process for the error correction encoding apparatus of FIG. 6;

FIG. 10 is a block diagram for schematically showing an error correction encoding apparatus for digital dual-stream broadcast transmission systems according to the third embodiment of the present invention;

FIG. 11 is a flow chart for showing an error correction encoding process for the error correction encoding apparatus of FIG. 8;

FIG. 12 is a block diagram for illustrating another TRS encoding unit for the error correction encoding apparatus according to an embodiment of the present invention;

FIG. 13 is a block diagram for schematically showing an error correction decoding apparatus for digital dual-stream broadcast reception systems according to an embodiment of the present invention;

FIG. 14 is a view for illustrating a TRS decoding unit of the error correction decoding apparatus according to an embodiment of the present invention;

FIG. 15 is a flow chart for showing an error correction decoding process for the error correction encoding apparatus according to the first embodiment of the present invention; and

FIG. 16 is a flow chart for showing an error correction decoding process for the error correction encoding apparatuses according to the second and third embodiments of the present invention.

### Best Mode

Hereinafter, the present invention will be described in detail with reference to the accompanying drawings.

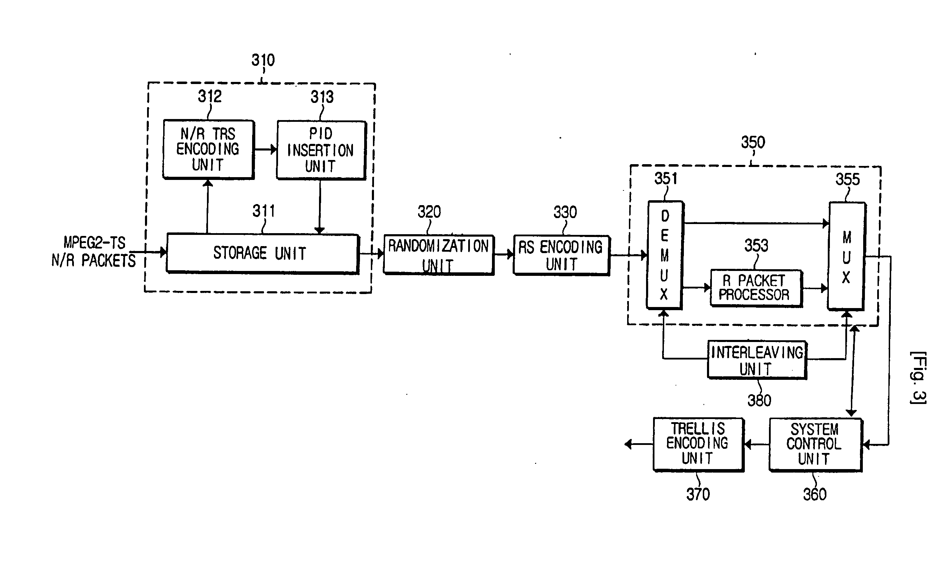

FIG. 3 is a block diagram for schematically showing an error correction encoding apparatus for digital dual-stream broadcast transmission systems according to the first embodiment of the present invention. The error correction encoding apparatus as shown in FIG. 3 has a TRS encoding part 310, a randomization unit 320, a Reed Solomon (RS) encoding unit 330, a packet format part 350, an interleaving unit 360, a Trellis encoding unit 370, and a system control unit 380.

The TRS encoding part 310 has a storage unit 311, an N/R TRS encoding unit 312, and a PID insertion unit 313, applies the transversal encoding to normal data packets and robust data packets to generate parity packets, and inserts packet headers (PIDs) in the generated parity packets.

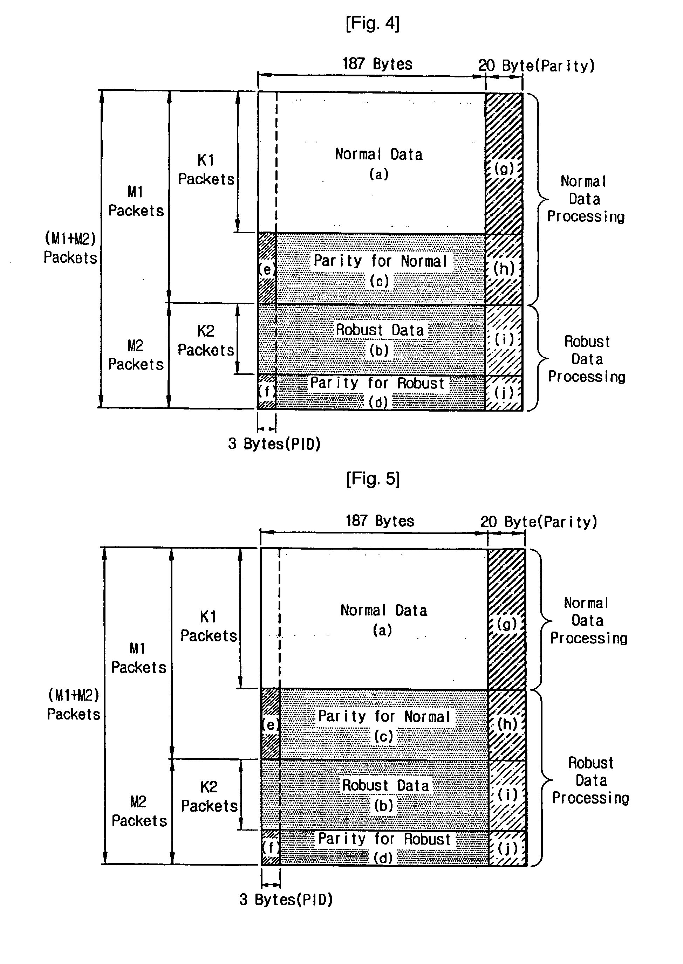

FIGS. 4 to 6 are views for showing structures of dual-stream transmission data frames according to the present invention. In FIGS. 4 to 6, the dual-stream transmission data frames are structured with normal data and robust data.

The TRS encoding part 310 applies the transversal encoding to data packets to append parity packets, and the parity packets are preferably appended in two methods as follows.

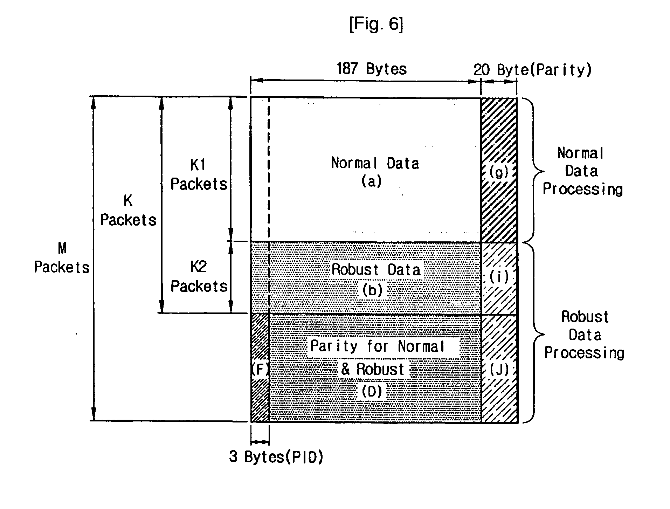

First, as shown in FIG. 4 and FIG. 5, there is a method appending (M1-K1) normal parity packets and (M2-K2) robust parity packets corresponding to K1 normal data packets and k2 robust data packets, respectively, and, second, as shown in FIG. 6, there is a method appending (M-(K1+K2)) parity packets to the entire packets of K1 normal data packets and K2 robust data packets.

The randomization unit 320 randomizes the data packets and parity packets in a predetermined pattern. The RS encoding unit 330 appends a parity of bytes to each of the randomized packets.

The packet format part 350 has a demultiplexer 351, an R packet processor 353, and a multiplexer 355, and splits input packets into the normal data and the robust data and processes the data corresponding to the packet formats under the controls of the system control unit 380.

The demultiplexer 351 splits input packets into the normal data and the robust data as shown in FIGS. 4 through 6, for example, according to the controls of the system control unit 380. As shown in FIG. 4, the demultiplexer 351 splits normal data packets and normal parity packets into the normal data, and robust parity packets and robust parity packets into the robust data, or, as shown in FIG. 5, splits the normal data packets into the normal data, and splits normal parity packets, robust data packets, and robust parity packets into the robust data.

Further, as shown in FIG. 6, the demultiplexer 351 splits the normal data packets into the normal data, and the robust data packets and parity packets into the robust data.

The packets split into the normal data by the demultiplexer 351 are processed as the normal data and outputted to the multiplexer 355, and the packets split into the robust data is processed to the robust data in certain ratios, for example, ½, and ¼, by the R packet processor 353, and outputted to the multiplexer 355.

The interleaving unit 360 interleaves and re-arranges the processed data packets in bytes according to packet formats. The Trellis encoding unit 370 applies the Trellis encoding to the interleaved data for re-arrangement into bits.

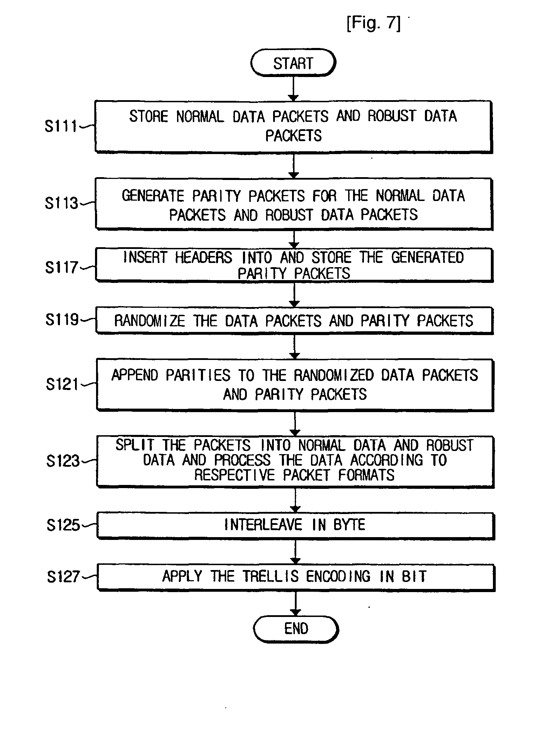

FIG. 7 is a flow chart for showing an error correction encoding process for the error correction encoding apparatus according to the first embodiment of FIG. 3. Hereinafter, description will be made in detail on the error correction encoding process according to the first embodiment of the present invention, with reference to FIGS. 4 through FIG. 6.

In an MPEG transmission system (not shown), normal data packets (a) and robust data packets (b) are stored in the storage unit 311 (S111).

The N/R TRS encoding unit 312 applies the transversal encoding to the normal data packets (a) and the robust data packets (b) to generate parity packets (S113). As shown in FIG. 4 and FIG. 6, normal parity packets (c) are generated with respect to the normal data packets (a), and robust parity packets (d) are generated with respect to the robust data packets (b). Further, as shown in FIG. 4C, the N/R TRS encoding unit 312 generates parity packets (D) with respect to the entire packets of the normal data packets (a) and robust data packets (b).

The PID insertion unit 313 inserts packet headers (PIDs) into parity packets (S115). As shown in FIG. 4 and FIG. 5, the headers (PIDs) (e) are inserted into the normal parity packets (b), and the headers (PID) (f) are inserted into the robust parity packets (b). Further, as shown in FIG. 4C, the headers (PIDs) (F) are inserted into the parity packets (D) generated for the entire packets of the normal data packets (a) and robust data packets (b).

As above, parity packets are generated for the normal data packets or the robust data packets, or for the entire packets, and headers (PIDs) are inserted into the generated parity packets, and then the parity packets are stored in the storage unit 311 (S117).

The randomization unit 320 randomizes the data packets and parity packets stored in the storage unit 311 in a predetermined pattern (S119).

The RS encoding unit 350 appends a parity of predetermined bytes to the randomized packets (S121). As shown in FIG. 4 through FIG. 6, parities of 20 bytes are appended.

The packet format part 350 splits input packets into the normal data and the robust data according to the controls of the system control unit 580, and processes the data according to the respective data formats (S123).

The interleaving unit 360 interleaves the data packets processed according to the respective data formats (S125), and the Trellis encoding unit 427 applies the Trellis encoding to the interleaved packets for re-arrangement in bit (S127).

### Mode for Invention

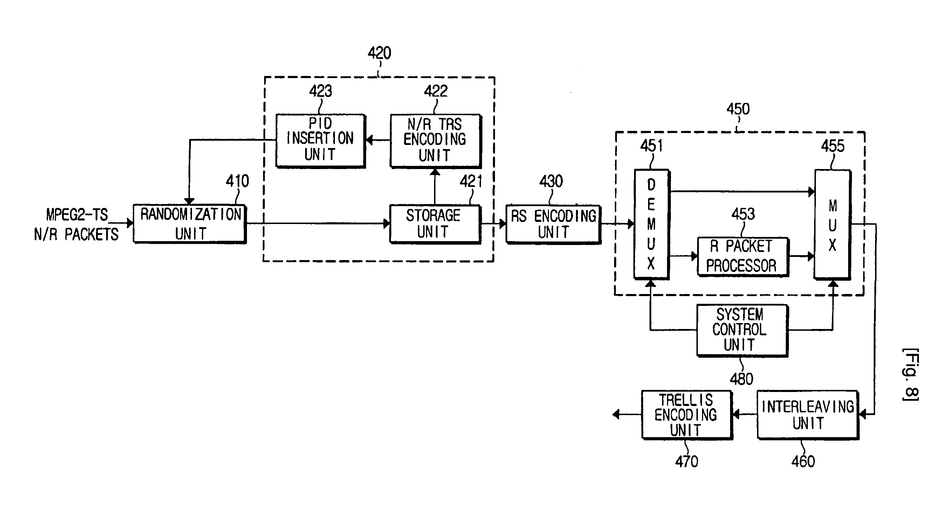

FIG. 8 is a block diagram for schematically showing an error correction encoding apparatus for the digital dual-stream broadcast transmission systems according to the second embodiment of the present invention. As shown in FIG. 8, the error correction encoding apparatus has a randomization unit 410, a TRS encoding part 420, an RS encoding unit 430, a packet format part 450, an interleaving unit 460, a Trellis encoding unit 470, and a system control unit 480.

The randomization unit 410 randomizes in a predetermined pattern the normal and robust data packets inputted from an MPEG transmission system (not shown), and parity packets fed back from the TRS encoding unit 420 as well.

The TRS encoding unit 420 has a storage unit 421, an N/R TRS encoding unit 422, and a PID insertion unit 423, applies the transversal encoding to the randomized normal data packets and robust data packets to generate parity packets, and inserts headers (PIDs) into the generated parity packets.

The RS encoding unit 430 appends parities of predetermined bytes to the randomized data and parity packets.

The packet format part 450 has a demultiplexer 451, an R packet processor 453, and a multiplexer 455, splits individual packets inputted according to the controls of the system control unit 480 into the normal data and the robust data, and process the split data according to respective data formats. In here, the packets can be diversely split into the normal and robust data as described in the first embodiment with reference to FIG. 4 through FIG. 6.

The interleaving unit 460 interleaves the packets processed according to data formats for re-arrangement in byte. The Trellis encoding unit 470 applies the Trellis encoding to the interleaved data for re-arrangement in bit.

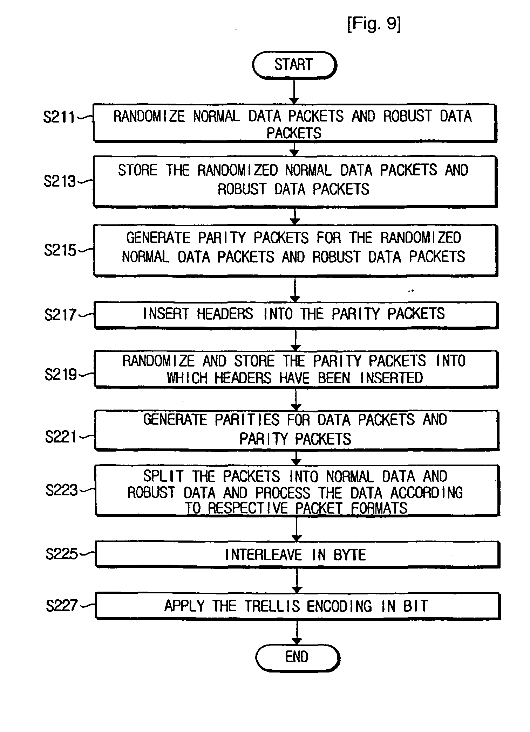

FIG. 9 is a flow chart for showing an error correction encoding process for the error correction encoding apparatus of FIG. 8 according to the second embodiment of the present invention. Hereinafter, description will be made in detail on the error correction encoding process according to the second embodiment with reference to FIG. 4 through FIG. 6.

The normal data packets (a) and the robust data packets (b) are inputted from the MPEG transmission system (not shown), and the randomization unit 410 randomizes the normal data packets (a) and the robust data packets (b) according to a predetermined pattern (S211).

The randomized normal data packets (a) and robust data packets (b) are stored in the storage unit 421 (S213).

The N/R TRS encoding unit 422 applies the transversal encoding to the randomized normal data packets (a) and robust data packets (b) to generate parity packets (S215). As shown in FIG. 4 and FIG. 5, the N/R TRS encoding unit 422 generates the normal parity packets (c) with respect to the normal data packets (a), and generates the robust parity packets (d) with respect to the robust data packet (b). Further, as shown in FIG. 6, the N/R TRS encoding unit 422 generates parity packets (D) with respect to the normal data packets (a), robust data packets (b), and the entire packets.

The PID insertion unit 423 inserts headers (PIDs) into parity packets (S217). As shown in FIG. 4, the PID insertion unit 423 inserts the headers (PIDs) (e) into the normal parity packets (b), and the headers (PIDs) (f) into the robust parity packets (b). Further, as shown in FIG. 6, the PID insertion unit 423 inserts the headers (PIDs) (F) into the parity packets (D) generated for the normal data packets (a), the robust data packets (b), and the entire packets.

As above, the parity packets into which the headers (PIDs) are inserted are fed back to the randomization unit 410, randomized according to a predetermined pattern, and stored in the storage unit 421 (S219).

The RS encoding unit 430 appends parities of predetermined bytes to data packets and parity packets that are stored in the storage unit 421 (S221). As shown in FIG. 4 through FIG. 6, the RS encoding unit 430 appends parities of 20 bytes to the packets.

The packet format part 450 splits input packets into the normal data and the robust data according to the controls of the system control unit 480, and processes data according to respective packet formats (S223).

The interleaving unit 460 interleaves the packets processed according to the data formats for re-arrangement in byte (S225), and the Trellis encoding unit 470 applies the Trellis encoding to the interleaved data for re-arrangement in bit (S227).

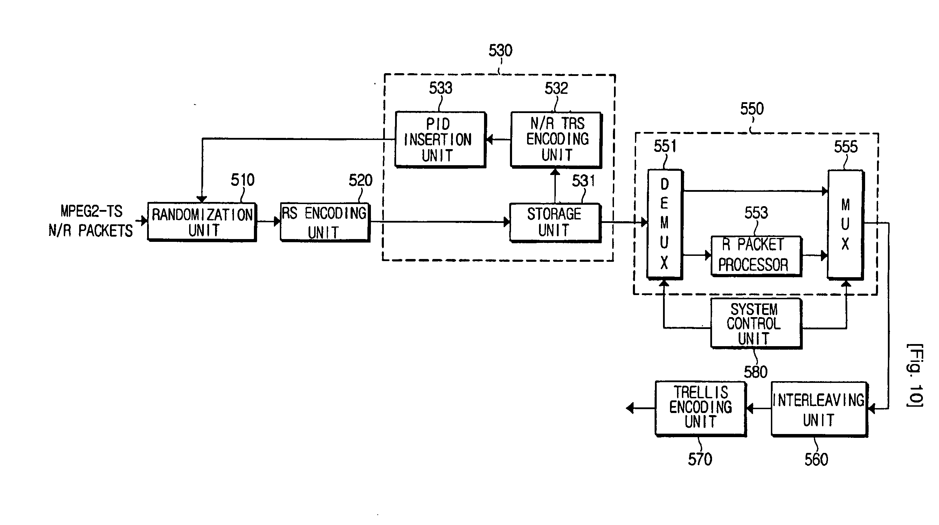

FIG. 10 is a block diagram for schematically showing an error correction encoding apparatus for digital dual-stream broadcast transmission systems according to the third embodiment of the present invention. As shown in FIG. 10, the error correction encoding apparatus has a randomization unit 510, an RS encoding unit 520, a TRS encoding part 530, a packet format part 550, an interleaving unit 560, a Trellis encoding unit 570, and a system control unit 580.

The randomization unit 510 randomizes according to predetermined patterns the normal data packets and the robust data packets that are outputted from the MPEG transmission system (not shown), and also randomizes the parity packets fed back from the TRS encoding part 530.

The RS encoding unit 520 appends parities of predetermined bytes to the randomized normal data packets and robust data packets, and also appends parities of predetermined bytes to the randomized parity packets fed back from the TRS encoding part 530.

The TRS encoding part 530 has a storage unit 531, an N/R TRS encoding unit 532, and a PID insertion unit 533, applies the transversal encoding to the parity-appended normal data packets and robust data packets to generate parity packets, and inserts headers (PIDs) into the generated parity packets.

In here, the process for generating the parity packets can generate parity packets for data packets to which parities are appended, and also generate parity packets for data packets except for parities. In case of the data packets to which parities are appended, packets go through a re-arrangement process before headers are inserted into the parity packets. That is, if the parity packets are generated with respect to the data packets including the parities, the parity packets have a size of 207 bytes. Thus, in consideration of 20-byte parities being appended by the RS encoding unit 520, the parity packets are re-arranged to the size of 187 bytes.

The packet format part 550 has a demultiplexer 551, an R packet processor 553, and a multiplexer 555, splits input packets into the normal data and the robust data according to the controls of the system control unit 580, and processes the data according to respective data formats. In here, the packets can be diversely split into the normal and robust data as described in the first embodiment with reference to FIG. 4 through FIG. 6.

The interleaving unit 560 interleaves the packets processed according to the packet formats for re-arrangement in byte. The Trellis encoding unit 570 applies the Trellis encoding to the interleaved data for re-arrangement in bit.

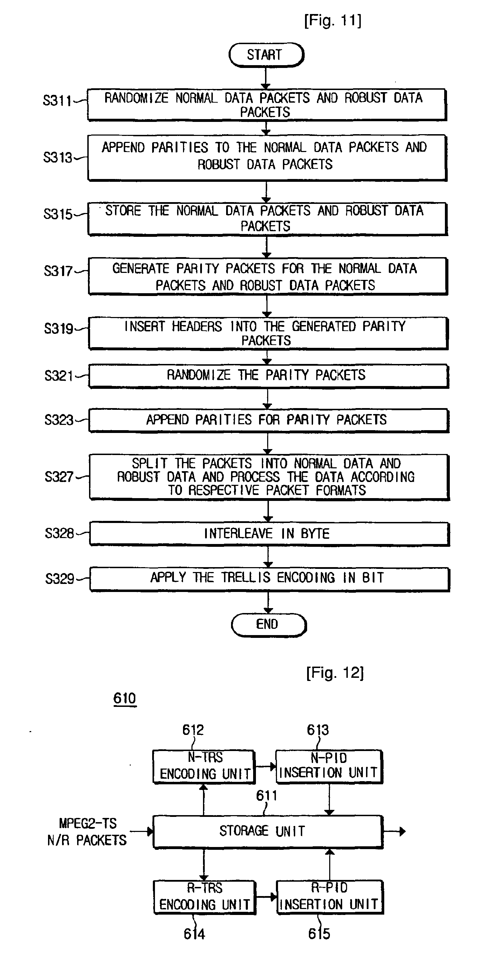

FIG. 11 is a flow chart for showing an error correction encoding process for the error correction encoding apparatus of FIG. 10 according to the third embodiment of the present invention. Hereinafter, description will be made in detail on the error correction encoding process according to the third embodiment of the present invention with reference to FIG. 4 through FIG. 6.

The normal data packets (a) and the robust data packets (b) are inputted from an MPEG transmission system (not shown), and the randomization unit 510 randomizes the normal data packets (a) and the robust data packets (b) according to a predetermined pattern (S311).

The RS encoding unit 520 appends parities of predetermined bytes to the randomized normal data packets (a) and robust data packets (b) (S313).

The storage unit 531 stores the normal data packets (a)(g) and the robust data packets (b)(i) to which parities have been appended (S315).

The N/R TRS encoding unit 532 generates parity packets with respect to the normal data packets (a)(g) and robust data packets (b)(i) that have been stored in the storage unit 531 (S317). In here, the process for generating the parity packets can be separated into a process for generating the parity packets with respect to the data packets except for the parities and a process for generating the parity packets with respect to the data packets including the parities.

In case of the data packets except for the parities, the N/R TRS encoding unit 532 applies the transversal encoding only to the data portions except for the parities (g)(i) with respect to the data packets stored in the storage unit 531 in order to generate the parity packets. As shown in FIG. 4 and FIG. 5, the N/R TRS encoding unit 532 generates the normal parity packets (c) and the robust parity packets (d) with respect to the normal data packets (a) and the robust data packets (b), or generates the parity packets (D) with respect to the normal data packets (a) and the robust data packets (d).

In case of the data packets including the parities, the N/R TRS encoding unit 532 applies the transversal encoding to the data packets including the parities (g)(i), and generates the parity packets (S317). That is, as shown in FIGS. 4 and 5, the N/R TRS encoding unit 532 generates the normal parity packet (c)(h) and robust parity packet (d)(j) with respect to the normal data packet (a)(g) and robust data packet (b)(i), or generates the parity packets (D)(J) with respect to the normal data packets (a)(g) and the robust data packets (d)(i). Next, the TRS encoding part 530 re-arranges the generated parity packets in predetermined bytes. For example, the TRS encoding part 530 re-arranges a generated parity packets of 207 bytes into parity packets of 187 bytes.

The PID insertion unit 533 inserts headers (PIDs) into the generated parity packets (S319). As shown in FIG. 4 and FIG. 5, the PID insertion unit 533 inserts the headers (PIDs) (e)(f) into the generated normal packets (c)(d), or, as shown in FIG. 6, the PID insertion unit 533 inserts the headers (PIDs) (F) into the generated parity packets (D).

As above, the parity packets generated from the TRS encoding part 530 are fed back to the randomization unit 510 for randomization (S321), and the RS encoding unit 520 appends parities of predetermined bytes to the randomized parity packets (S323). As shown in FIG. 4 and FIG. 5, the parities (h)(j) of 20 bytes are appended to the randomized normal parity packets (c) and robust parity packets (d), or, as shown in FIG. 6, the parities (J) of 20 bytes are appended to the randomized parity packets (D).

The parity packets to which the parities of predetermined bytes are appended in the RS encoding unit 520 are stored in the storage unit 531 (S325). That is, the storage unit 531 stores one field data as shown in FIG. 4 through FIG. 6.

The packet format part 550 splits input packets into the normal data and the robust data according to the controls of the system control unit 580, and processes data according to respective packet formats (S327).

The interleaving unit 560 interleaves the packets processed according to the data formats for re-arrangement in byte (S328), and the Trellis encoding unit 570 applies the Trellis encoding to the interleaved data for re-arrangement in bit (S320).

As aforementioned, the error correction encoding apparatuses for dual-stream broadcasts according to the first to third embodiments of the present invention have been described to be provided with the TRS encoding unit having the storage unit, N/R TRS encoding unit, and PID insertion unit, but the apparatuses can be a TRS encoding part 610 as shown in FIG. 12.

As shown in FIG. 12, the TRS encoding part 610 has a storage unit 611 for storing normal data packets and robust data packets, an N-TRS encoding unit 612 for applying the transversal encoding to the normal data packets and generating normal parity packets, an N-PID insertion unit 613 for inserting headers (PIDs) into the normal parity packets, an R-TRS encoding unit 614 for encoding the transversal encoding to the robust data packets and generating the robust parity packets, and an R-PID insertion unit 615 for inserting headers (PIDs) into the robust parity packets.

That is, the TRS encoding parts according to the first to third embodiments shown in FIG. 3, FIG. 7, and FIG. 10 can be replaced with the TRS encoding part 610 shown in FIG. 12.

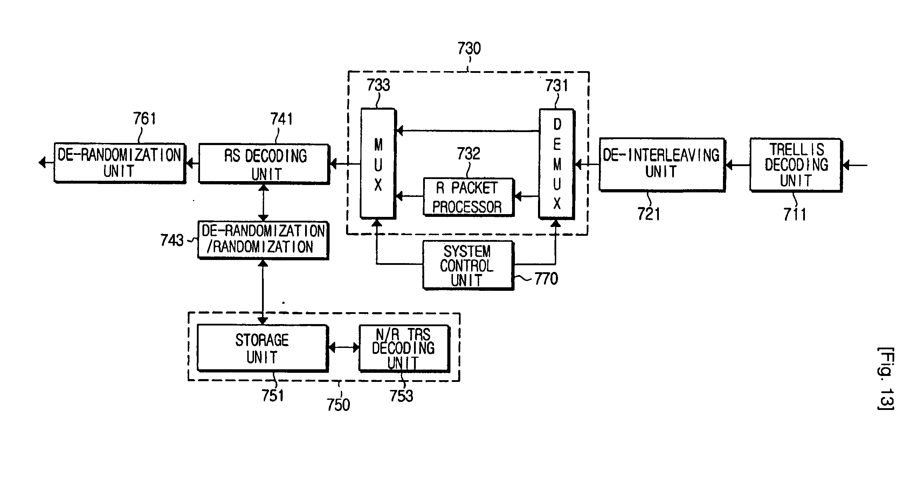

FIG. 13 is a block diagram for schematically showing an error correction decoding apparatus for dual-stream corresponding to the error correction encoding apparatus for dual stream according to an embodiment of the present invention.

The error correction decoding apparatus has a Trellis decoding unit 711, a de-interleaving unit 721, a packet re-format part 730, an RS decoding unit 741, a de-randomization/randomization unit 743, a TRS decoding part 750, and de-randomization unit 761.

The Trellis decoding unit 711 and the de-interleaving unit 721 applies the Trellis decoding and deinterleaving corresponding to the Trellis encoding and interleaving applied at the transmission side.

The packet reformat part 730 has a de-multiplexer 731, an R packet processor 732, and a multiplexer 733, splits input packets into normal data and robust data according to the controls of the system control unit 770, and processes data corresponding to respective data formats.

The de-multiplexer 731 splits packets in correspondence with formats of the packets split at the transmission side, as shown in FIG. 4 and FIG. 6, for example, according to the controls of the system control unit 770.

The de-multiplexer 731 outputs to the multiplexer 733 the packets that have been split into the normal data, and the R packet processor 732 processes the packets that have been split into the robust data into the normal data according to certain ratios, for example, ½ and ¼, of the transmission side, and outputs the normal data to the multiplexer 733.

The RS decoding unit 741 corrects errors in the row direction of the field data by use of the parities of predetermined bytes included in the packets.

The de-randomization/randomization unit 743 randomizes packets according to a predetermined pattern. If the TRS encoding unit is used before the randomization unit as in the first embodiment, the de-randomization/randomization unit 743 at the transmission side randomizes all the data and parity packets, and, if the TRS encoding unit is used after the randomization unit as in the second and third embodiments, the de-randomization/randomization unit 743 randomizes only the parity packets.

The TRS decoding part 750 has a storage unit 751 and an N/R TRS decoding unit 753, and corrects packet errors in the column direction by use of parity packets. The storage unit 751 stores data error-corrected at the RS decoding unit 741 and N/R TRS decoding unit 753, information of whether or not error has been corrected, and so on.

The de-randomization unit 761 de-randomizes according to a predetermined pattern the data packets that have been error-corrected in the row direction in the RS decoding unit 741.

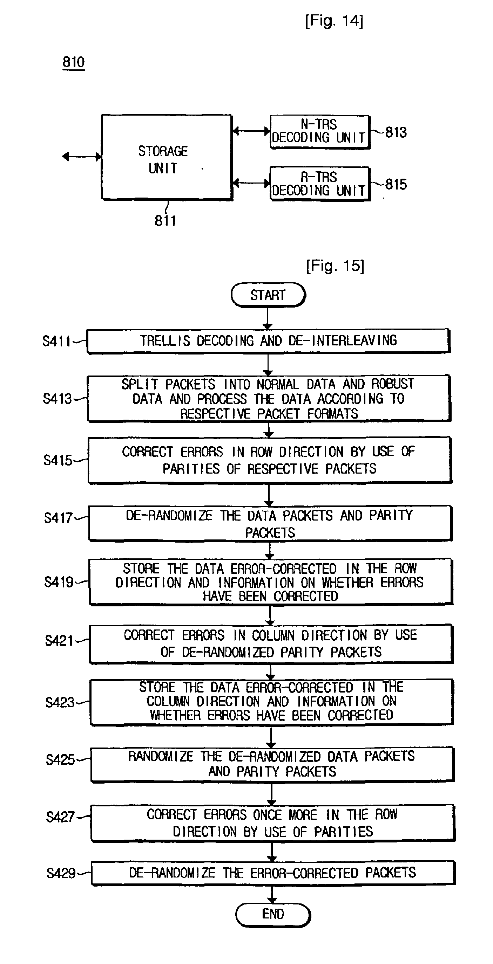

In the error correction decoding apparatus for dual stream according to the present invention as above, the TRS decoding part 750 has been described to include the storage unit 751 and the N/R TRS decoding unit 753, but the TRS decoding part 810 as shown in FIG. 14 can be used for the N/R TRS decoding part 750.

As shown in FIG. 14, the TRS decoding part 810 has a storage unit 811 for storing data packets and parity packets, an N-TRS decoding unit 813 for applying the transversal decoding unit 813 to normal data packets by use of normal parity packets, and an R-TRS decoding unit 815 for applying the transversal decoding to robust data packets by use of robust parity packets. That is, the TRS decoding part 750 as shown in FIG. 13 can be replaced with the TRS decoding part 810 as shown in FIG. 14.

FIG. 15 is a flow chart for showing an error correction decoding process for the error correction encoding apparatus according to the first embodiment of FIG. 3.

The Trellis decoding unit 711 and the de-interleaving unit 721 applies the Trellis encoding used at the transmission side, and applies the Trellis decoding and de-interleaving corresponding to the interleaving at the transmission side (S411).

The packet re-format part 730 splits the de-interleaved packets into normal data packets and robust data packets, and processes data corresponding to respective packet formats (S413).

The RS decoding unit 741 uses 20-byte parities (g)(h)(i)(j) included in the packets to correct packet errors in the row direction of field data (S415).

The de-randomization/randomization unit 743 de-randomizes all the data packets and parity packets (S417). In here, in the error correction encoding of the first embodiment, the parity packets generated from the TRS encoding part 310 are de-randomized packets generated based on the de-randomized data packets since the TRS encoding part 310 is disposed before the randomization unit 320. Therefore, the de-randomization/randomization unit 743 de-randomizes all the data packets and parity packets.

The storage unit 751 stores data error-corrected in the row direction in the RS decoding unit 743 and information on whether errors have been corrected (S419).

The N/R TRS decoding unit 753 uses the de-randomized parity packets stored in the storage unit 751 to correct errors in the column direction with respect to the de-randomized data packets (S421).

Next, the data stored in the storage unit 751 is updated based on the data error-corrected in the column direction in the N/R TRS decoding unit 753 and the information on whether the errors have been corrected (S423).

The de-randomization/randomization unit 743 re-randomizes the de-randomized data packets and parity packets stored in the storage unit 751 (S425). In here, the RS encoding unit 330 of the error correction encoding apparatus of FIG. 3 randomizes the data packets and the parity packets before the RS decoding unit 741 applies the RS decoding since parities have been appended to the randomized data packets and parity packets.

The RS decoding unit 741 uses 20-byte parities to correct errors once more with respect to the randomized data packets and parity packets (S427).

The de-randomized unit 761 de-randomizes the error-corrected data according to a predetermined pattern, so the reception system terminates its error correction (S429).

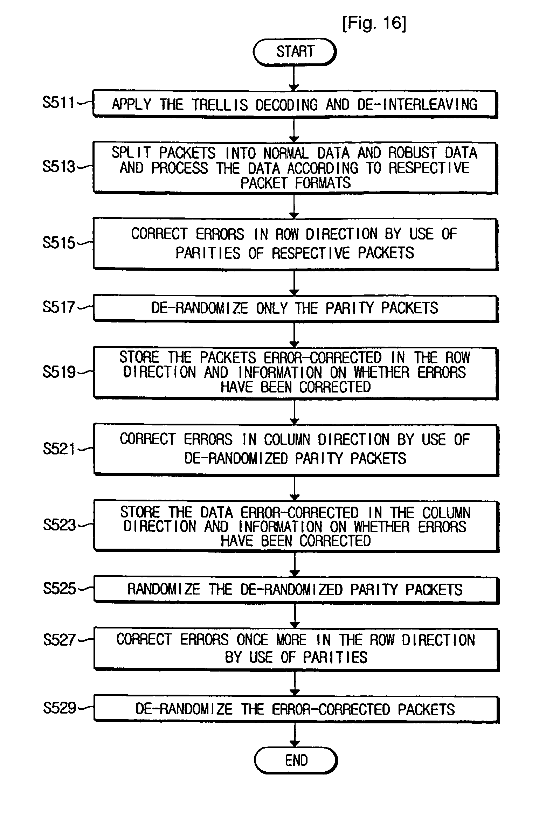

FIG. 16 is a flow chart for showing an error correction decoding processor for the error correction decoding apparatuses according to the second and third embodiments as shown in FIG. 8 and FIG. 10, and description will be made on an error correction decoding process for the second and third embodiments with reference through FIG. 16.

The Trellis decoding unit 711 and the de-interleaving unit 721 applies the Trellis encoding used at the transmission side, and applies the Trellis decoding and de-interleaving corresponding to the interleaving at the transmission side(S511).

The packet re-format part 730 splits the de-interleaved packets into normal data packets and robust data packets, and processes data corresponding to respective packet formats (S513).

The RS decoding unit 741 uses 20-byte parities included in the packets to correct packet errors in the row direction of field data (S515).

The de-randomization/randomization unit 743 de-randomizes only the parity packets (S517). In here, the de-randomization/randomization unit 743 de-randomizes only the parity packets since the TRS encoding part of the error correction encoding apparatuses shown in FIG. 8 and FIG. 10 is disposed behind the randomization unit and the parity packets generated from the TRS encoding part are de-randomized packets generated based on the randomized data packets.

The storage unit 751 stores data error-corrected in the row direction in the RS decoding unit 743 and information on whether errors have been corrected (S519).

The N/R TRS decoding unit 753 uses the de-randomized parity packets stored in the storage unit 751 to correct errors in the column direction with respect to the randomized data packets (S521).

Next, the N/R TRS decoding unit 753 updates the data stored in the storage unit 751 based on the data error-corrected in the column direction and the information on whether the errors have been corrected (S523).

The de-randomization/randomization unit 743 re-randomizes the de-randomized data packets stored in the storage unit 751 (S525). In here, the RS encoding unit of the error correction encoding apparatuses shown in FIG. 8 and FIG. 10, randomizes the de-randomized parity packets stored in the storage unit 751 before the RS decoding unit 741 applies the RS decoding since parities are appended to the randomized data packets and parity packets.

The RS decoding unit 741 uses 20-byte parities to correct errors once more with respect to the randomized data packets and parity packets (S527).

The de-randomized unit 761 de-randomizes the error-corrected data according to a predetermined pattern, so the reception system terminates its error correction (S529).

### Industrial Applicability

The present invention relates to an error correction encoding/decoding apparatus for American ATSC digital terrestrial broadcast reception/transmission systems, and more particularly to a robust error correction encoding/decoding apparatus and method for digital dual-stream broadcast reception/transmission systems which split data into normal and robust data for processing, receiving, and transmitting the data.

## Claims

1. A digital broadcast system comprising a reception device to receive error correction coded normal data and robust data processed robustly from a digital broadcast transmission device comprising an error correction coding unit including a first encoder and a second encoder, a trellis encoder, and an interleaving unit, at least one error correction coded normal and robust data comprising a predetermined number of at least one of normal and robust data packets, using the first encoder, parity packets being added to the normal and robust data packets column-by-column, and parities being generated by the second encoder corresponding to the normal and robust data packets and the parity packets, and being added to the normal and robust data packets and the parity packets row-by-row, the reception device comprising:
a de-multiplexer (731) configured to split input packets received from the transmission device into the at least robust data; and
an error correction decoding device configured to correct the received error correction coded at least robust data, the error correction decoding device comprising:
a trellis decoder (711) to trellis decode the at least robust data trellis encoded by the trellis encoder in the transmitter device;
a first decoder (741) configured to decode a predetermined number of the at least robust data packets using the parities of a predetermined number of bytes included in the at least robust data; and
a second decoder (750) configured to decode the at least robust data packets decoded in the first decoder using the parity packets.

2. The digital broadcast system of claim 1 wherein parity packets are appended to correspond to each of the normal data packet and the robust data packet.

3. The digital broadcast system of claim 1, wherein parity packets are appended to correspond to normal data and the robust data packets together.

4. An error-correction decoder to decode error-correction coded normal data and robust data processed robustly, at least one error-correction coded normal data and robust data comprising at least one of a predetermined number of normal and robust data packets, parity packets appended to the normal and robust data packets column-by-column, and parities appended to the normal and robust data packets row-by-row, the error-correction decoder comprising:
a first decoder (741) to decode the normal and robust data using the parities, and
a second decoder (750) to decode the normal and robust data using the parity packets.

5. The error-correction decoder of claim 4, wherein the first decoder uses the parities to decode the at least one of the normal and robust data after the second decoder decodes the at least one of the normal and robust data using the parity packets.

6. The error-correction decoder of claim 4, wherein the second decoder uses the parity packets to decode the at least one of the normal and robust data after the first decoder decodes the at least one of the normal and robust data using the parities.

7. The error-correction decoder of claim 4, wherein the parity packets are appended to the at least one of normal and robust data packets by rows and the parities are appended to the at least one of normal and robust data packets by columns.

8. The error-correction decoder of claim 4, wherein the parity packets are appended to the at least one of normal and robust data packets by columns and the parities are appended to the at least one of normal and robust data packets by rows.

9. The error-correction decoder of claim 4, wherein the parities are appended to correspond to the at least one of normal and robust data packets and the corresponding appended parity packet.

10. The error-correction decoder of claim 4, wherein the parities are appended to correspond to the at least one of normal and robust data packets.

11. The error-correction decoder of claim 4, wherein the at least one of the error-correction coded normal data and robust data is trellis encoded, and the error-correction decoder further comprises:
a trellis decoder to trellis decode the at least one of normal and robust data trellis encoded.

12. The error-correction decoder of claim 4, wherein the at least one of error-correction coded normal data and robust data comprises normal and robust data, and the error-correction decoder further comprises
a packet re-format unit (730) to split input normal and robust data packets and corresponding parity packets into normal data and robust data, and to process the packets according to respective data formats corresponding to the normal and robust data;

13. The error-correction decoder of claim 12, wherein parity packets are appended to correspond to each of the normal data packet and to the robust data packet.

14. The error-correction decoder of claim 12, wherein parity packets are appended to correspond to normal data and the robust data packets together.

## Patentansprüche

1. Digitales Broadcast-System, aufweisend eine Empfangsvorrichtung zum Empfangen von fehlerkorrekturcodierten normalen Daten und robusten Daten, die von einer digitalen Broadcast-Sendevorrichtung robust verarbeitet sind, aufweisend eine Fehlerkorrekturcodiereinheit, die einen ersten Codierer und einen zweiten Codierer, einen Trellis-Codierer und eine Verschachtelungseinheit aufweist, wobei mindestens eines der fehlerkorrekturcodierten normalen und robusten Daten eine vorbestimmte Anzahl von mindestens einem von normalen und robusten Datenpaketen aufweisen, wobei unter Verwendung des ersten Codierers Paritätspakete spaltenweise zu den normalen und robusten Datenpaketen hinzugefügt werden und durch den zweiten Codierer Paritäten generiert werden, die den normalen und robusten Datenpaketen und den Paritätspaketen entsprechen und reihenweise zu den normalen und robusten Datenpaketen und den Paritätspaketen hinzugefügt werden, wobei die Empfangsvorrichtung Folgendes aufweist:
einen Demultiplexer (731), der so konfiguriert ist, dass er Eingangspakete, die von der Sendevorrichtung empfangen werden, in die mindestens robusten Daten teilt; und
eine Fehlerkorrekturcodiervorrichtung, die so konfiguriert ist, dass sie die empfangenen fehlerkorrekturcodierten mindestens robusten Daten korrigiert, wobei die Fehlerkorrekturcodiervorrichtung Folgendes aufweist:
einen Trellis-Decodierer (711) zum Trellis-Decodieren der mindestens robusten Daten, die durch den Trellis-Codierer in der Sendevorrichtung trellis-codiert wurden;
einen ersten Decodierer (741), der so konfiguriert ist, dass er eine vorbestimmte Anzahl der mindestens robusten Datenpakete unter Verwendung der Paritäten einer vorbestimmten Anzahl von Bytes decodiert, die in den mindestens robusten Daten enthalten sind; und
einen zweiten Decodierer (750), der so konfiguriert ist, dass er die mindestens robusten Datenpakete, die im ersten Decodierer decodiert wurden, unter Verwendung der Paritätspakete decodiert.

2. Digitales Broadcast-System nach Anspruch 1, wobei Paritätspakete angehängt werden, um jedem von dem normalen Datenpaket und dem robusten Datenpaket zu entsprechen.

3. Digitales Broadcast-System nach Anspruch 1, wobei Paritätspakete angehängt werden, um normalen Daten und den robusten Datenpaketen zusammen zu entsprechen.

4. Fehlerkorrekturdecodierer zum Decodieren von fehlerkorrekturcodierten normalen Daten und robusten Daten, die robust verarbeitet sind, wobei mindestens eines der fehlerkorrekturcodierten normalen Daten und robusten Daten mindestens eines von einer vorbestimmten Anzahl von normalen und robusten Datenpaketen aufweisen, Paritätspakete spaltenweise an die normalen und robusten Datenpakete angehängt werden, und Paritäten reihenweise an die normalen und robusten Datenpakete angehängt werden, wobei der Fehlerkorrekturdecodierer Folgendes aufweist:
einen ersten Decodierer (741) zum Decodieren der normalen und robusten Daten unter Verwendung der Paritäten, und
einen zweiten Decodierer (750) zum Decodieren der normalen und robusten Daten unter Verwendung der Paritätspakete.

5. Fehlerkorrekturdecodierer nach Anspruch 4, wobei der erste Decodierer die Paritäten zum Decodieren der mindestens einen von den normalen und robusten Daten verwendet, nachdem der zweite Decodierer die mindestens einen von den normalen und robusten Daten unter Verwendung der Paritätspakete decodiert.

6. Fehlerkorrekturdecodierer nach Anspruch 4, wobei der zweite Decodierer die Paritätspakete zum Decodieren der mindestens einen von den normalen und robusten Daten verwendet, nachdem der erste Decodierer die mindestens einen von den normalen und robusten Daten unter Verwendung der Paritäten decodiert.

7. Fehlerkorrekturdecodierer nach Anspruch 4, wobei die Paritätspakete durch Reihen an die mindestens einen von normalen und robusten Datenpaketen angehängt werden und die Paritäten durch Spalten an die mindestens einen von normalen und robusten Datenpaketen angehängt werden.

8. Fehlerkorrekturdecodierer nach Anspruch 4, wobei die Paritätspakete durch Spalten an die mindestens einen von normalen und robusten Datenpaketen angehängt werden und die Paritäten durch Reihen an die mindestens einen von normalen und robusten Datenpaketen angehängt werden.

9. Fehlerkorrekturdecodierer nach Anspruch 4, wobei die Paritäten angehängt werden, um den mindestens einen von normalen und robusten Datenpaketen und dem entsprechenden angehängten Paritätspaket zu entsprechen.

10. Fehlerkorrekturdecodierer nach Anspruch 4, wobei die Paritäten angehängt werden, um den mindestens einen von normalen und robusten Datenpaketen zu entsprechen.

11. Fehlerkorrekturdecodierer nach Anspruch 4, wobei die mindestens einen der fehlerkorrekturcodierten normalen Daten und robusten Daten trellis-codiert sind, und der Fehlerkorrekturdecodierer ferner Folgendes aufweist:
einen Trellis-Decodierer zum Trellis-Decodieren der mindestens einen von trellis-codierten normalen und robusten Daten.

12. Fehlerkorrekturdecodierer nach Anspruch 4, wobei die mindestens einen von fehlerkorrekturcodierten normalen Daten und robusten Daten normale und robuste Daten aufweisen, und der Fehlerkorrekturdecodierer ferner Folgendes aufweist:
eine Paketreformatiereinheit (730) zum Teilen von normalen und robusten Datenpaketen und entsprechenden Paritätspaketen in normale Daten und robuste Daten und zum Verarbeiten der Pakete gemäß jeweiligen Datenformaten, die den normalen und robusten Daten entsprechen.

13. Fehlerkorrekturdecodierer nach Anspruch 12, wobei Paritätspakete angehängt werden, um jedem von dem normalen Datenpaket und dem robusten Datenpaket zu entsprechen.

14. Fehlerkorrekturdecodierer nach Anspruch 12, wobei Paritätspakete angehängt werden, um normalen Daten und den robusten Datenpaketen zusammen zu entsprechen.

## Revendications

1. Système de diffusion numérique comprenant un dispositif de réception pour recevoir des données normales et des données robustes codées de correction d'erreurs traitées de manière robuste depuis un dispositif de transmission de diffusion numérique comprenant une unité de codage de correction d'erreurs comprenant un premier codeur et un second codeur, un codeur à treillis et une unité d'entrelacement, au moins une des données normales et des données robustes codées de correction d'erreurs comprenant un nombre prédéterminé d'au moins un des paquets de données normales et robustes, à l'aide du premier codeur, des paquets de parité étant ajoutés aux paquets de données normales et robustes, colonne par colonne, et des parités étant générées par le second codeur correspondant aux paquets de données normales et robustes et aux paquets de parité, et étant ajoutés aux paquets de données normales et robustes et aux paquets de parité, rangée par rangée, le dispositif de réception comprenant :
un démultiplexeur (731) configuré pour scinder les paquets d'entrée reçus du dispositif de transmission en au moins les données robustes ; et
un dispositif de décodage de correction d'erreurs configuré pour corriger au moins les données robustes codées de correction d'erreurs reçues, le dispositif de décodage de correction d'erreurs comprenant :
un décodeur en treillis (711) pour décoder en treillis au moins les données robustes codées en treillis par le codeur en treillis dans le dispositif transmetteur ;
un premier décodeur (741) configuré pour décoder un nombre prédéterminé au moins des paquets de données robustes à l'aide des parités d'un nombre prédéterminé d'octets compris dans au moins les données robustes; et
un second décodeur (750) configuré pour décoder au moins les paquets de données robustes décodés dans le premier décodeur à l'aide des paquets de parité.

2. Système de diffusion numérique selon la revendication 1, dans lequel des paquets de parité sont ajoutés pour correspondre à chacun du paquet de données normales et du paquet de données robustes.

3. Système de diffusion numérique selon la revendication 1, dans lequel des paquets de parité sont ajoutés pour correspondre aux paquets de données normales et de données robustes, ensemble.

4. Décodeur de correction d'erreurs destiné à décoder des données normales et des données robustes codées de correction d'erreurs traitées de manière robuste, au moins une des données normales et des données robustes codées de correction d'erreurs comprenant au moins un paquet d'un nombre prédéterminé de paquets de données normales et robustes, de paquets de parité ajoutés aux paquets de données normales et robustes, colonne par colonne, et de parités ajoutées aux paquets de données normales et robustes, rangée par rangée, le décodeur de correction d'erreurs comprenant :
un premier décodeur (741) pour décoder les données normales et robustes à l'aide des parités, et
un second décodeur (750) pour décoder les données normales et robustes à l'aide des paquets de parités.

5. Décodeur de correction d'erreurs selon la revendication 4, dans lequel le premier décodeur utilise les parités pour décoder l'au moins une donnée des données normales et robustes après que le second décodeur a décodé l'au moins une donnée des données normales et robustes à l'aide des paquets de parité.

6. Décodeur de correction d'erreurs selon la revendication 4, dans lequel le second décodeur utilise les paquets de parité pour décoder l'au moins une donnée des données normales et robustes après que le premier décodeur a décodé l'au moins une donnée des données normales et robustes à l'aide des parités.

7. Décodeur de correction d'erreurs selon la revendication 4, dans lequel les paquets de parité sont ajoutés à l'au moins un paquet des paquets de données normales et robustes par colonnes et les parités sont ajoutées à l'au moins un paquet des paquets de données normales et robustes par colonnes.

8. Décodeur de correction d'erreurs selon la revendication 4, dans lequel les paquets de parité sont ajoutés à l'au moins un paquet des paquets de données normales et robustes par colonnes et les parités sont ajoutées à l'au moins un paquet des paquets de données normales et robustes par rangées.

9. Décodeur de correction d'erreurs selon la revendication 4, dans lequel les parités sont ajoutées pour correspondre à l'au moins un paquet des paquets de données normales et robustes et au paquet de parité ajouté correspondant.

10. Décodeur de correction d'erreurs selon la revendication 4, dans lequel les parités sont ajoutées à l'au moins un paquet des paquets de données normales et robustes.

11. Décodeur de correction d'erreurs selon la revendication 4, dans lequel l'au moins une donnée des données normales et des données robustes codées de correction d'erreur est codée en treillis, et le décodeur de correction d'erreurs comprend en outre :
un décodeur en treillis pour décoder en treillis au moins une donnée des données normales et robustes codées en treillis.

12. Décodeur de correction d'erreurs selon la revendication 4, dans lequel l'au moins une donnée des données normales et des données robustes codées de correction d'erreur comprend des données normales et robustes, et le décodeur à correction d'erreurs comprend en outré :
une unité de remise au format (730) pour scinder des paquets de données normales et robustes d'entrée et des paquets de parité correspondant en données normales et robustes, et pour traiter les paquets en fonction des formats de données respectifs correspondant aux données normales et robustes.

13. Décodeur de correction d'erreurs selon la revendication 12, dans lequel des paquets de parité sont ajoutés pour correspondre à chacun du paquet de données normales et du paquet de données robustes.

14. Décodeur de correction d'erreurs selon la revendication 12, dans lequel des paquets de parité sont ajoutés pour correspondre aux paquets de données normales et de données robustes, ensemble.
